# EUROPEAN PATENT APPLICATION

(11) **EP 3 796 087 A1**
(43) Date of publication of application: **24.03.2021**
(21) Application number: 19198515.9
(22) Date of filing: 20.09.2019
(51) Int. Cl.: G03F 7/20

(54) **DETERMINING LITHOGRAPHIC MATCHING PERFORMANCE**

(71) Applicant: ASML Netherlands B.V., 5500 AH Veldhoven (NL)
(72) Inventor: CUI, Yingchao, 5500 AH Veldhoven (NL); YAGUBIZADE, Hadi, 5500 AH Veldhoven (NL); SLOTBOOM, Daan, Maurits, 5500 AH Veldhoven (NL); PARK, Jeonghyun, 5500 AH Veldhoven (NL)
(74) Representative: ASML Netherlands B.V.

(57) **Abstract**

A method for determining lithographic matching performance includes obtaining first monitoring data (E1M, E3M, E4M) from recurrent monitoring for stability control for the available EUV scanners (EUV1, EUV3 and EUV4). For a DUV scanner, second monitoring data (D2M), is similarly obtained from recurrent monitoring (DMW, MT, OV, SM) for stability control. The EUV monitoring data (E1M, E3M, E4M) are in a first layout. The DUV monitoring data (D2M) are in a second layout. A cross-platform overlay matching performance between the first lithographic apparatus and the second lithographic apparatus is determined based on the first monitoring data and the second monitoring data. This is done by reconstructing (900, 1000) at least one of the first and second monitoring data into a common layout (E1S, E3S, E4S, D2S) to allow comparison (802) of the first and second monitoring data.

## Description

### FIELD

The present invention relates to methods of determining lithographic matching performance between lithographic apparatuses for semiconductor manufacture, a semiconductor manufacturing processes, a lithographic apparatus, a lithographic cell and associated computer program products.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm deep ultraviolet (DUV), 193 nm deep ultraviolet (DUV) and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a DUV lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

Cross-platform, for example DUV to EUV, matching performance between lithographic apparatuses is vital for on-product overlay performance. Conventionally, this is achieved using a dedicated verification test. This test requires certain machine setup procedure as a pre-requisite that takes hours of time. Extra scanner and metrology time is required for pre-setup, exposure and overlay measurement. The test is performed only when it is very necessary and therefore cannot be used for daily monitoring purposes, which is necessary for high-volume manufacturing.

### SUMMARY

It is desirable to provide a method of determining lithographic matching performance between lithographic apparatuses that solves the above-discussed problem.

Embodiments of the invention are disclosed in the claims and in the detailed description.

In a first aspect of the invention there is provided a method of determining lithographic matching performance between lithographic apparatuses for semiconductor manufacture, the method comprising the steps:
- obtaining first monitoring data from recurrent monitoring for stability control of a first lithographic apparatus;
- obtaining second monitoring data from recurrent monitoring for stability control of a second lithographic apparatus;
- determining a lithographic matching performance between the first lithographic apparatus and the second lithographic apparatus based on the first monitoring data and the second monitoring data.

Preferably, the first monitoring data are in a first layout, the second monitoring data are in a second layout, and the step of determining a lithographic matching performance comprises reconstructing at least one of the first and second monitoring data into a common layout to allow comparison of the first and second monitoring data.

In a second aspect of the invention there is provided a semiconductor manufacturing process comprising a method for determining lithographic matching performance according to the first aspect.

In a third aspect of the invention there is provided a lithographic apparatus comprising:
- an illumination system configured to provide a projection beam of radiation;
- a support structure configured to support a patterning device, the patterning device configured to pattern the projection beam according to a desired pattern;
- a substrate table configured to hold a substrate;
- a projection system configured the project the patterned beam onto a target portion of the substrate; and
- a processing unit configured to determine lithographic matching performance according to the method of the first aspect.

In a fourth aspect of the invention there is provided a lithographic cell comprising the lithographic apparatus of the third aspect.

In a fifth aspect of the invention there is provided a computer program product comprising machine readable instructions for causing a general-purpose data processing apparatus to perform the steps of a method according to the first aspect.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic overview of control mechanisms in a lithographic process utilizing a scanner stability module;
- Figure 5 depicts a schematic overview of normal operation of a set of DUV and EUV lithographic apparatuses with recurrent monitoring for stability control;
- Figure 6 depicts the problem of unavailability of a lithographic apparatus, necessitating cross-platform lithographic matching;
- Figure 7 depicts a test for determining cross-platform lithographic matching performance using a conventional approach;
- Figure 8 depicts an overview of a method of determining lithographic matching performance between lithographic apparatuses, according to an embodiment of the present invention;
- Figure 9 depicts processing of EUV monitoring data for determining lithographic matching performance with reconstruction of monitoring data, according to an embodiment of the present invention; and
- Figure 10 depicts processing of DUV monitoring data for determining lithographic matching performance, according to an embodiment of the present invention.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

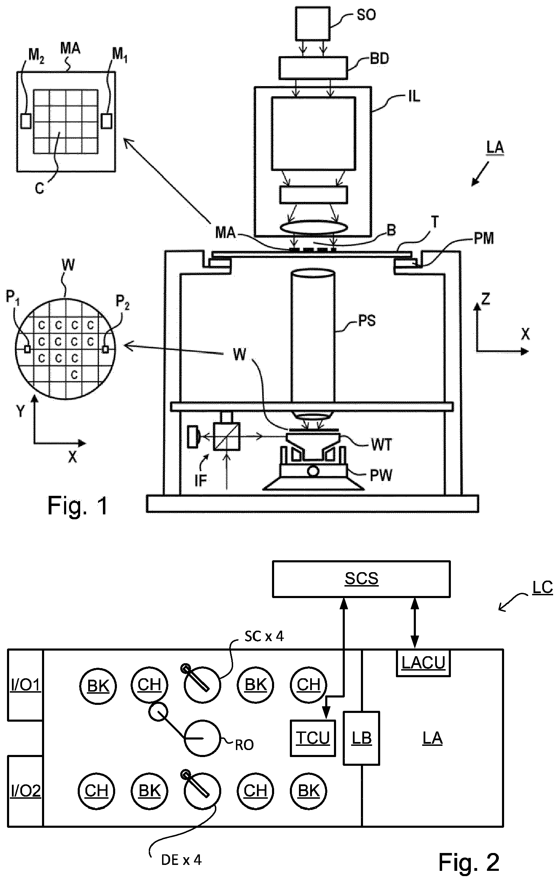

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports 1/01, 1/02, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

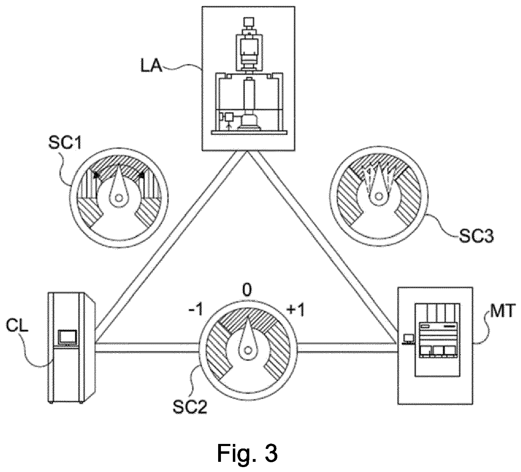

Typically, the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

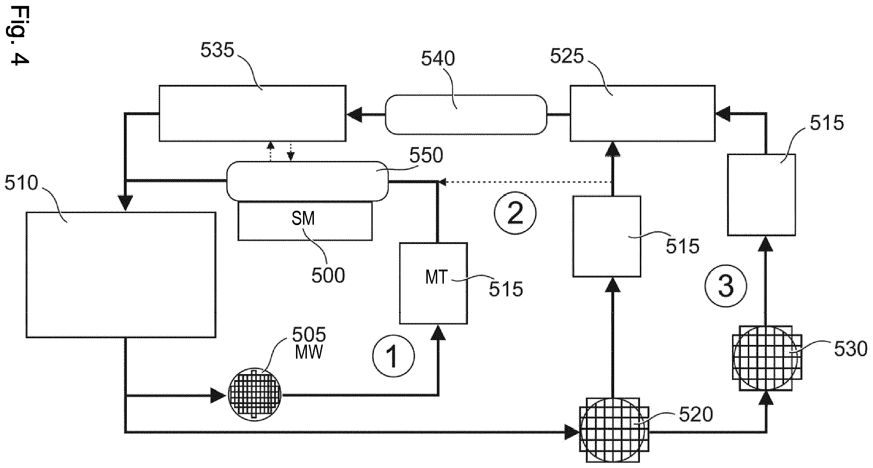

Figure 4 depicts the overall lithography and metrology method incorporating a stability module 500 (essentially an application running on a server, in this example). Shown are three main process control loops, labeled 1, 2, 3. The first loop provides recurrent monitoring for stability control of the lithography apparatus using the stability module 500 and monitor wafers. A monitor wafer (MW) 505 is shown being passed from a lithography cell 510, having been exposed to set the baseline parameters for focus and overlay. At a later time, metrology tool (MT) 515 reads these baseline parameters, which are then interpreted by the stability module (SM) 500 so as to calculate correction routines so as to provide scanner feedback 550, which is passed to the main lithography apparatus 510, and used when performing further exposures. The exposure of the monitor wafer may involve printing a pattern of marks on top of reference marks. By measuring overlay error between the top and bottom marks, deviations in performance of the lithographic apparatus can be measured, even when the wafers have been removed from the apparatus and placed in the metrology tool.

The second (APC) loop is for local scanner control on-product (determining focus, dose, and overlay on product wafers). The exposed product wafer 520 is passed to metrology unit 515 where information relating for example to parameters such as critical dimension, sidewall angles and overlay is determined and passed onto the Advanced Process Control (APC) module 525. This data is also passed to the stability module 500. Process corrections 540 are made before the Manufacturing Execution System (MES) 535 takes over, providing control of the main lithography apparatus 510, in communication with the scanner stability module 500.

The third control loop is to allow metrology integration into the second (APC) loop (e.g., for double patterning). The post etched wafer 530 is passed to metrology unit 515 which again measures parameters such as critical dimensions, sidewall angles and overlay, read from the wafer. These parameters are passed to the Advanced Process Control (APC) module 525. The loop continues the same as with the second loop.

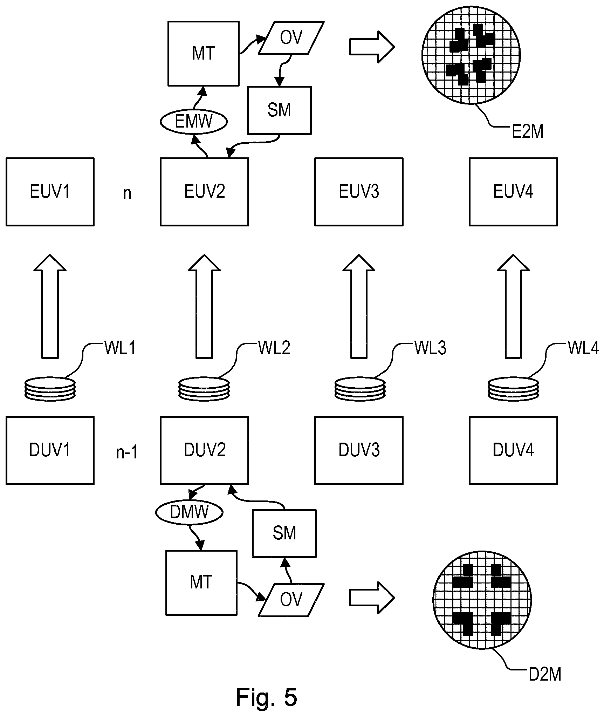

Figure 5 depicts a schematic overview of normal operation of a set of lithographic apparatuses with recurrent monitoring for stability control. In the examples given below, the lithographic apparatuses are scanners. Four deep UV scanners DUV1 to DUV4 are shown having processed four wafer lots WL1 to WL4 at a lithographic exposure step n-1. These wafer lots are then processed in the next lithographic exposure step n in four extreme UV scanners EUV1 to EUV4. The wafer lots have dedicated routes. For example a wafer lot WL1 exposed in a deep UV scanner DUV1 and then exposed in an extreme UV scanner EUV1.

Each scanner has a process for recurrent monitoring for stability control, as described with reference to Figure 4. Monitoring data are obtained by measuring one or more monitoring substrates periodically processed on the respective lithographic apparatus. In Figure 5, for example, an extreme UV Scanner EUV2 processes a monitor wafer EMW which is measured in a metrology tool MW which outputs overlay measurements OV to a stability module SM. The overlay measurements OV are recorded as an wafer map E2M comprising a grid of overlay measurements (which may be represented as overlay residuals). Thus, first monitoring data E2M is obtained from recurrent monitoring for stability control of a first lithographic apparatus EUV2. The first monitoring data E2M are in a first layout. For example, each datum has a particular location on the substrate where it was measured. Also, depicted in this example, a deep UV scanner DUV2 processes a monitor wafer DMW which is measured in a metrology tool MW which outputs overlay measurements OV to a stability module SM. The overlay measurements OV are recorded as an wafer map D2M comprising a grid of overlay measurements. Thus, second monitoring data D2M is obtained from recurrent monitoring for stability control of a second lithographic apparatus DUV2. The second monitoring data D2M are in a second layout, different from the first layout. This difference comes from different layout and density of the features on the monitor wafers EMW and DMW and differences in the sample schemes for overlay measurement. This is to be expected with different platforms such as DUV and EUV.

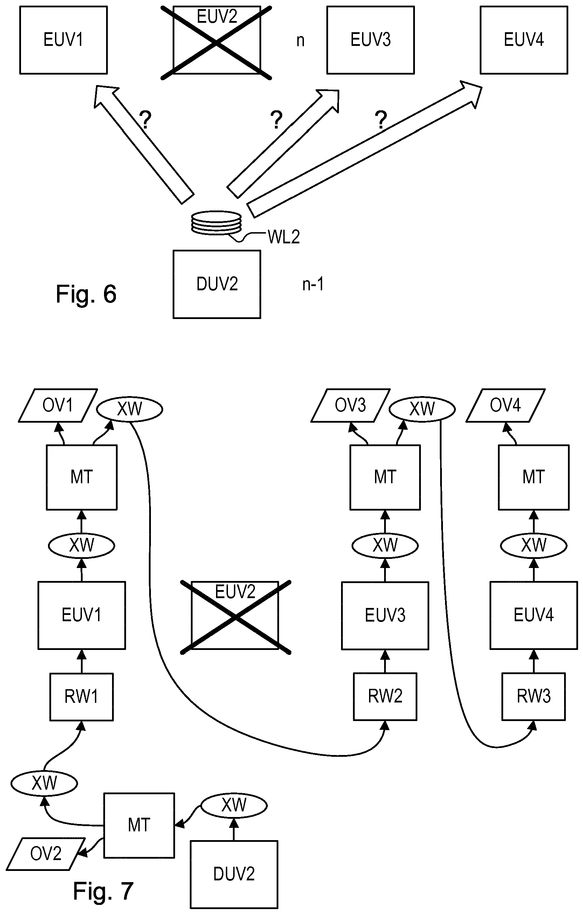

Figure 6 depicts the problem of unavailability of a lithographic apparatus, necessitating cross-platform lithographic matching. Selected scanners are shown from Figure 5. One of the EUV scanners EUV2 is not available for production, perhaps because it is down for preventive maintenance. Therefore, the question arises: Where should the wafer lot WL2 from the second DUV scanner DUV2 be processed next? Which of the available EUV scanners EUV1, EUV3 or EUV4 should be used? The answer can be found by determining which of the EUV scanners has the best overlay matching performance with the DUV scanner DUV2.

Figure 7 depicts determining cross-platform lithographic matching performance using a conventional approach. A cross-platform test wafer XW is exposed on the second DUV scanner DUV2 and metrology tool MT measures the overlay OV2. The test wafer XW is reworked RW1 and exposed in the first EUV tool EUV1. Next, the metrology tool MT measures the overlay OV1. The test wafer XW is reworked RW2 and exposed in the third EUV tool EUV3. The metrology tool MT then measures the overlay OV3. Finally, The test wafer XW is reworked RW3 and exposed in the fourth EUV tool EUV4. The metrology tool MT then measures the overlay OV4. The cross-platform overlay matching performance between the second DUV scanner DUV2 and the first EUV scanner EUV1 is determined by calculating the difference between the respective overlay measurements OV2 and OV1. This is repeated for each of the remaining EUV scanners (i.e. OV2-OV3 and OV2-OV4). The differences are ranked and the EUV scanner with the smallest difference is determined to have the best overlay matching performance. Then the wafer lot WL2 is routed through that scanner. The dedicated verification test described with reference to Figure 7 requires a scanner setup procedure as a pre-requisite that takes hours of time. It is performed only when it is very necessary and therefore cannot be used for daily monitoring purposes, which is necessary for a high-volume manufacturing environment.

Embodiments provide a methodology to determine the cross-platform matching performance using the outputs from recurrent monitoring for stability control (drift control, DC).

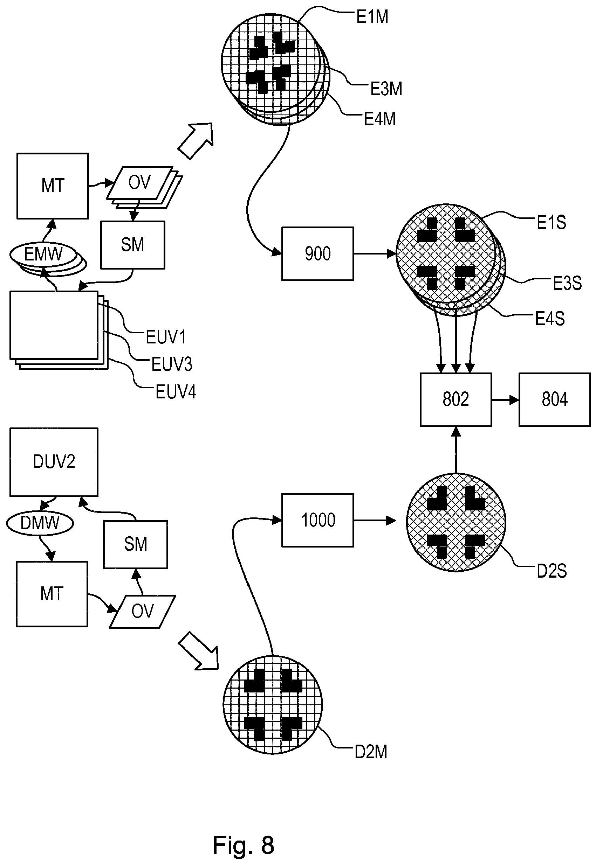

Figure 8 depicts an overview of a method of determining lithographic matching performance between lithographic apparatuses for semiconductor manufacture.

First monitoring data E1M, E3M, E4M is obtained from recurrent monitoring (by monitor wafer EMW, metrology tool MT, overlay measurements OV, and stability module SM) for stability control for the available EUV scanners EUV1, EUV3 and EUV4. For the second DUV scanner, second monitoring data D2M is similarly obtained from recurrent monitoring (DMW, MT, OV, SM) for stability control. The EUV monitoring data E1M, E3M, E4M are in a first layout. The DUV monitoring data D2M are in a second layout.

The DUV monitoring data D2M is preferably chosen to have the same (or close to the same, such as the same day) exposure time that the wafer lot in question was exposed at for layer n-1. It will better reflect the overlay performance of that DUV scanner which is desired to be matched, for that wafer lot. Thus, for example with reference to Figures 5 and 8, consider the matching of scanner DUV2 to one of the EUV scanners EUV 1,3,4. For routing of a wafer lot WL2 with bottom layer n-1 exposed at a time t ∼ T₀ on DUV scanner DUV2, one of the EUV scanners EUV1,3,4 is selected based on monitoring data D2M for which the DUV monitoring wafer DMW was also exposed at time t ∼ T₀. That monitoring data is compared to current EUV monitoring data, the match is determined, and the EUV processing step proceeds as soon as possible, before the selected EUV scanner's performance drifts. Thus, the first monitoring data D2M is obtained from exposures of the one or more monitoring substrates that were contemporaneous (t ∼ T₀) with exposure of the wafer lot (one or more substrate) WL2 to be exposed in the second lithographic apparatus EUV1,3,4 depending on the determination of the lithographic matching performance.

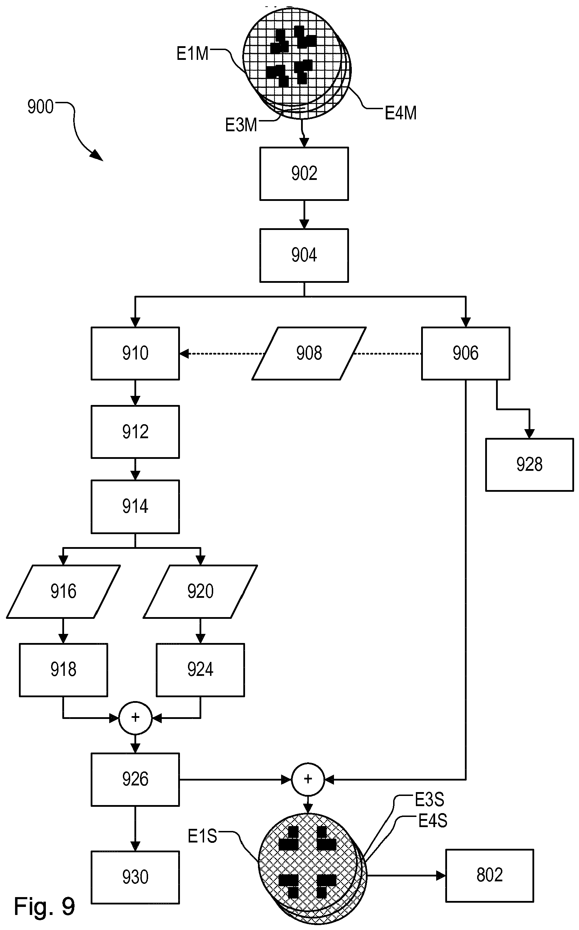

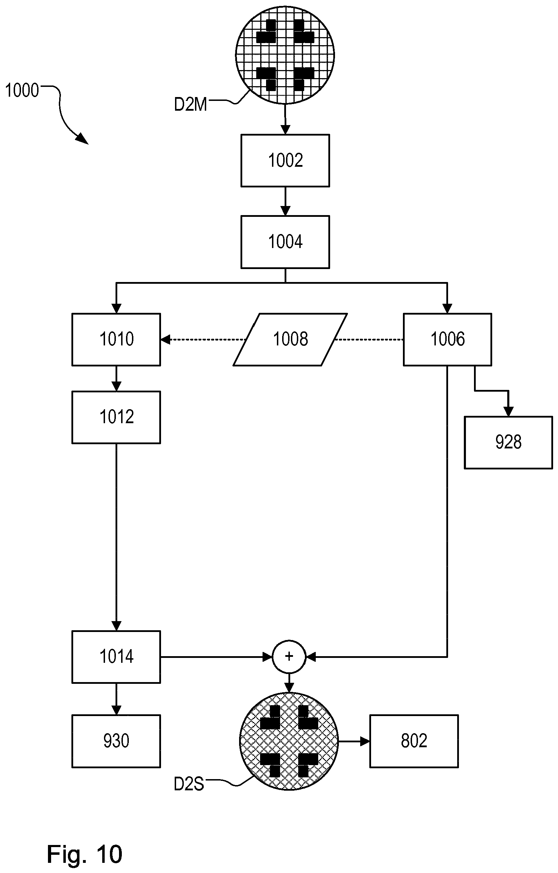

Cross-platform overlay matching performance between the first lithographic apparatuses EUV1, EUV3, EUV4 and the second lithographic apparatus DUV2 is determined based on the first monitoring data and the second monitoring data. This may be done by reconstructing 900, 1000 (as described with reference to Figures 9 and 10) at least one of the first and second monitoring data into a common layout (e.g. a simulated wafer map) E1S, E3S, E4S, D2S to allow comparison 802 of the first and second monitoring data.

The cross-platform overlay matching performance between the second DUV scanner DUV2 and the first EUV scanner EUV1 is determined by calculating 802 the difference between the respective monitoring data in the common layout D2S and E2S. This is repeated for each of the remaining EUV scanners (i.e. D2S-E3S and D2S-E4S). The differences are ranked 804 and the EUV scanner with the smallest difference is determined to have the best overlay matching performance. Then the wafer lot WL2 from the second DUV scanner DUV2 is routed through that EUV scanner.

Figure 9 depicts processing 900 of EUV monitoring data for determining lithographic matching performance with reconstruction of monitoring data.

Figure 10 depicts processing 1000 of DUV monitoring data for determining lithographic matching performance.

With reference to Figures 9 and 10, densely-sampled intra-field data are processed separately 906, 1006 from inter-field (whole-wafer) data for the EUV and DUV monitoring data respectively. In this example this includes decomposing inter-field and intra-field data, but in other examples the raw inter-field and intra-field data may already be separated so decomposition is not needed. These intra-field data correspond to a lithographic exposure field with the same sampling same layout, i.e. 13x19 points per field. Direct subtraction is performed to calculate the intra-field matching fingerprint (i.e. the cross-field pattern). For the inter-field fingerprint matching for the EUV monitoring data, the inter-field components of wafer maps E1M, E3M and E4M are re-constructed (as detailed with reference to Figure 9) into a common layout E1S, E3S and E4S. With reference to Figures 8 to 10, a conventional cross-platform test wafer layout is used as an example common layout. But in practice, other common layouts can be selected to achieve a good accuracy. Finally, the intra-field data is added back to inter-field data, then a complete wafer map is ready for comparison to determine the lithographic matching performance.

With reference to Figure 9, for EUV, starting from the monitoring data E1M, E3M, E4M (described with reference to Figure 8), filtering and modeling is applied 902, including wafer error correction and reticle error correction. Then the data is split 904 into chuck 1 and chuck 2 data (as these scanners have two wafer chucks to support the wafers during exposure). The monitoring data comprise inter-field data (fingerprint) corresponding to a plurality of lithographic exposure fields. The monitoring data also comprise intra-field data corresponding to a lithographic exposure field. The intra-field average fingerprint 908 is calculated 906. For each chuck, the intra-field average fingerprint is removed 910 from the whole-wafer inter-field data. The field average fingerprint 908 used here can be calculated from dense fields (e.g. configured to minimize a quadratic component of overlay, induced by lens distortion) or average of all inner fields, including dense fields and sparse sampled fields. Then all the wafers from the same chuck are averaged 912. Afterwards, a high order global model and another additional model, e.g. wafer-edge model, are applied 914 to the wafer map. Thus the step of reconstructing comprises fitting the respective monitoring data to a (global) model of a lithographic process of the respective lithographic apparatus to predict reconstructed monitoring data in the common layout. The models here are used to capture physical fingerprints on the wafer map. Residuals of these model contains mainly noise errors other than the physical fingerprint. The model parameters (correctable errors) 920 are mapped 924 to the selected common layout. Thus the step of reconstructing further comprises mapping fitted parameters of the model to the common layout. For the residual (non-correctable errors) 916, interpolation 918 is used to map it to the same common layout. Linear or other type of interpolation may be used. Thus the step of reconstructing further comprises interpolating residuals from the fitting to the common layout. The correctable errors and non-correctable errors (now mapped/interpolated the common layout) are added together to provide the monitoring data 926 in the common layout E1S, E3S, E4S. Thus the separately processed inter-field and intra-field data are combined to allow comparison of the first and second monitoring data in a common layout. Then the monitoring data re-construction for the inter-field data is complete. Finally a comparison 802 is performed to determine the lithographic matching performance (as described with reference to step 802 in Figure 8).

With reference to Figure 10, For DUV, the flow is different in this example because the monitoring data contains multiple images with different exposure layouts. Starting from monitoring data D2M (described with reference to Figure 8), filtering and modeling is applied 1002 and the data is split 1004 per chuck, in the same was same as for EUV, described with reference to Figure 9. For the intra-field fingerprint matching, the dense fields are also used by calculating 1006 an intra-field average fingerprint 1008. To get an inter-field fingerprint, the intra-field average fingerprint (dense field) per image and per wafer is removed 1010, an average of all the wafer per image is performed 1012, and then all images are averaged 1014. In the end, the intra-field average fingerprint calculated 1006 from dense fields can be added back for a complete simulated wafer map DS2. Finally a comparison 802 is performed to determine the lithographic matching performance .

After all these flows, the monitoring data wafer maps from EUV and DUV are now in the same layout, and matching performance can be calculated 802 using direct subtraction to calculate differences (as described with reference to step 802 in Figure 8). The differences are ranked 804 (as described with reference to step 802 in Figure 8) and the EUV scanner with the lowest difference is determined to have the best overlay matching performance. Then the wafer lot WL2 from the second DUV scanner DUV2 is routed through that EUV scanner.

Additionally or alternatively, ranking may be performed by comparison 928 (also in Figure 9) of the intra-field average fingerprints 908 and 1008. This can be used for scanner-to-scanner lens matching. Similarly, additionally or alternatively, ranking may be performed by comparison 930 (also in Figure 9) of the inter-field reconstructed monitoring data.

Embodiments provide lithographic performance matching without additional cost or time, while the accuracy is good for matching. Recurrent monitoring for stability control is normally performed every 3 days for each scanner at semiconductor manufacturing site. Therefore, it can be used for monitoring purposes and to inform semiconductor manufacturers about optimal scanner-to-scanner pairing.

The scope of this method is not limited to EUV to DUV matching. It can also be used for DUV to DUV and EUV to EUV matching, for example if different monitor wafer layouts are used for the same platform, as long as there is recurrent monitoring for stability control (drift control) being used.

Embodiments may be implemented in a semiconductor manufacturing process comprising a method for determining lithographic matching performance described with reference to Figures 8 to 10.

Embodiments may be implemented in a lithographic apparatus, such as described with reference to Figure 1, comprising:
- an illumination system configured to provide a projection beam of radiation;
- a support structure configured to support a patterning device, the patterning device configured to pattern the projection beam according to a desired pattern;
- a substrate table configured to hold a substrate;
- a projection system configured the project the patterned beam onto a target portion of the substrate; and
- a processing unit configured to determine a correction to a process according to a method described with reference to Figures 8 to 10.

Embodiments may be implemented in a lithographic apparatus, such as described with reference to Figure 2.

Embodiments may be implemented in a computer program product comprising machine readable instructions for causing a general-purpose data processing apparatus to perform the steps of a method described with reference to Figures 8 to 10.

Further embodiments are disclosed in the list of numbered clauses below:
1. A method of determining lithographic matching performance between lithographic apparatuses for semiconductor manufacture, the method comprising the steps:
   - obtaining first monitoring data from recurrent monitoring for stability control of a first lithographic apparatus;
   - obtaining second monitoring data from recurrent monitoring for stability control of a second lithographic apparatus;
   - determining a lithographic matching performance between the first lithographic apparatus and the second lithographic apparatus based on the first monitoring data and the second monitoring data.
2. The method of clause 1, wherein:
   - the first monitoring data are in a first layout;
   - the second monitoring data are in a second layout; and
   - the step of determining a lithographic matching performance comprises reconstructing at least one of the first and second monitoring data into a common layout to allow comparison of the first and second monitoring data.
3. The method of clause 2, wherein the step of reconstructing comprises fitting the respective monitoring data to a model of a lithographic process of the respective lithographic apparatus to predict reconstructed monitoring data in the common layout.
4. The method of clause 3, wherein the step of reconstructing further comprises mapping fitted parameters of the model to the common layout.
5. The method of clause 3 or 4, wherein the step of reconstructing further comprises interpolating residuals from the fitting to the common layout.
6. The method of any preceding clause, wherein the monitoring data comprise inter-field data corresponding to a plurality of lithographic exposure fields.
7. The method of any preceding clause, wherein the monitoring data comprise intra-field data corresponding to a lithographic exposure field.
8. The method of clause 7 further comprising processing the inter-field data separately from the intra-field data.
9. The method of clause 8, further comprising combining the separately processed inter-field intra-field data to allow comparison of the first and second monitoring data in a common layout.
10. The method of any preceding clause, wherein the lithographic matching performance comprises overlay matching performance.
11. The method of any preceding clause, wherein the monitoring data comprise a grid of overlay measurements.
12. The method of any preceding clause, wherein the monitoring data comprise a wafer map.
13. The method of any preceding clause, wherein the monitoring data are obtained by measuring one or more monitoring substrates periodically processed on the respective lithographic apparatus.
14. The method of clause 13, wherein the first monitoring data is obtained from exposures of the one or more monitoring substrates that were contemporaneous with exposure of one or more substrate to be exposed in the second lithographic apparatus depending on the determination of the lithographic matching performance.
15. A semiconductor manufacturing process comprising a method for determining lithographic matching performance according to the method of any preceding clause.
16. A lithographic apparatus comprising:
   - an illumination system configured to provide a projection beam of radiation;
   - a support structure configured to support a patterning device, the patterning device configured to pattern the projection beam according to a desired pattern;
   - a substrate table configured to hold a substrate;
   - a projection system configured the project the patterned beam onto a target portion of the substrate; and
   - a processing unit configured to determine lithographic matching performance according to the method of any of clauses 1 to 14.
17. A lithographic cell comprising the lithographic apparatus of clause 16.
18. A computer program product comprising machine readable instructions for causing a general-purpose data processing apparatus to perform the steps of a method according to any of clauses 1 to 14.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). It is also to be noted that the term metrology apparatus or metrology system encompasses or may be substituted with the term inspection apparatus or inspection system. A metrology or inspection apparatus as disclosed herein may be used to detect defects on or within a substrate and/or defects of structures on a substrate. In such an embodiment, a characteristic of the structure on the substrate may relate to defects in the structure, the absence of a specific part of the structure, or the presence of an unwanted structure on the substrate, for example.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of physical systems such as structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of a physical structure may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A method of determining lithographic matching performance between lithographic apparatuses for semiconductor manufacture, the method comprising the steps:
- obtaining first monitoring data from recurrent monitoring for stability control of a first lithographic apparatus;
- obtaining second monitoring data from recurrent monitoring for stability control of a second lithographic apparatus;
- determining a lithographic matching performance between the first lithographic apparatus and the second lithographic apparatus based on the first monitoring data and the second monitoring data.

2. The method of claim 1, wherein:
- the first monitoring data are in a first layout;
- the second monitoring data are in a second layout; and
- the step of determining a lithographic matching performance comprises reconstructing at least one of the first and second monitoring data into a common layout to allow comparison of the first and second monitoring data.

3. The method of claim 2, wherein the step of reconstructing comprises fitting the respective monitoring data to a model of a lithographic process of the respective lithographic apparatus to predict reconstructed monitoring data in the common layout.

4. The method of claim 3, wherein the step of reconstructing further comprises mapping fitted parameters of the model to the common layout.

5. The method of claim 3 or 4, wherein the step of reconstructing further comprises interpolating residuals from the fitting to the common layout.

6. The method of any preceding claim, wherein the monitoring data comprise inter-field data corresponding to a plurality of lithographic exposure fields.

7. The method of any preceding claim, wherein the monitoring data comprise intra-field data corresponding to a lithographic exposure field.

8. The method of claim 7 further comprising processing the inter-field data separately from the intra-field data.

9. The method of claim 8, further comprising combining the separately processed inter-field intra-field data to allow comparison of the first and second monitoring data in a common layout.

10. The method of any preceding claim, wherein the lithographic matching performance comprises overlay matching performance.

11. The method of any preceding claim, wherein the monitoring data comprise a grid of overlay measurements.

12. The method of any preceding claim, wherein the monitoring data comprise a wafer map.

13. The method of any preceding claim, wherein the monitoring data are obtained by measuring one or more monitoring substrates periodically processed on the respective lithographic apparatus.

14. The method of claim 13, wherein the first monitoring data is obtained from exposures of the one or more monitoring substrates that were contemporaneous with exposure of one or more substrate to be exposed in the second lithographic apparatus depending on the determination of the lithographic matching performance.

15. A semiconductor manufacturing process comprising a method for determining lithographic matching performance according to the method of any preceding claim.
